Europäisches Patentamt

(19) European Patent Office

Office européen des brevets

(11) Publication number: **0 184 917**
**B1**

(12) **EUROPEAN PATENT SPECIFICATION**

(45) Date of publication of patent specification: **04.07.90**

(21) Application number: **85308526.4**

(22) Date of filing: **25.11.85**

(51) Int. Cl.⁵: **C 23 C 14/40, B 05 D 3/06,
C 23 C 14/48, C 23 F 1/08,
B 01 J 19/08, H 01 J 37/32,
H 01 L 21/203, H 01 L 21/306**

(54) Plasma reactor vessel and process.

(30) Priority: **13.12.84 GB 8431422**

(43) Date of publication of application:
**18.06.86 Bulletin 86/25**

(45) Publication of the grant of the patent:
**04.07.90 Bulletin 90/27**

(84) Designated Contracting States:
**AT BE CH DE FR IT LI LU NL SE**

(56) References cited:
**EP-A-0 027 578     DE-A-3 103 177
EP-A-0 032 788     DE-A-3 214 626
EP-A-0 104 916     DE-B-2 810 554
DE-A-2 340 442     GB-A-2 105 729
DE-A-2 848 691     US-A-4 333 814
DE-A-3 015 034     US-A-4 358 686
PATENT ABSTRACTS OF JAPAN, unexamined
applications, C field, vol. 6, no. 227, November
12, 1982, page 144 C 134**

(73) Proprietor: **STC PLC
1B Portland Place
London W1N 3AA (GB)**

(72) Inventor: **Heinecke, Rudolf August
14 The Drive
Harlow Essex (GB)**
Inventor: **Ojha, Sureshchandra Mishrilal
79 Carters Mead
Harlow Essex (GB)**
Inventor: **Llewellyn, Ian Paul
217 The Dashes
Harlow Essex (GB)**

(74) Representative: **Ryan, John Peter William et al
STC Patents West Road
Harlow Essex CM20 2SH (GB)**

EP 0 184 917 B1

Courier Press, Leamington Spa, England.

## Description

This invention relates to pulsed radio frequency plasma treatment of substrate bodies and in particular to a reactor vessel for use in said treatment.

Plasma processing and in particular low temperature glow discharge plasma processing is potentially a very useful process for the surface processing of substrate materials. As a source of high energy radiation it can promote both physical and chemical changes at the surface of the substrate and can be used for etching, roughening, grafting and coating of the surface. It is possible to include more than one of these processes during a treatment so that one can sequentially carry out surface etching, cross-linking and layer or multilayer deposition of a substrate by simply changing the gas composition. Such a process ensures the maximum possible adherence and compatability between different deposited layers and avoids other problems such as internal optical reflection caused by abrupt interfaces.

A significant development in plasma processing is the introduction of high intensity pulsed radio frequency techniques. Such a process is disclosed in our published specification No. 2105729A (R. A. H. Heinecke-S. M. Ojha-M. J. Cooke 30-2-2) which relates to a process for surface processing a heat sensitive substrate material comprising exposing the surface of the substrate to a high intensity radio frequency pulsed plasma of low average power, the plasma pulse producing a power density of at least a few Kw per litre, typically about 100 w/cm$^3$.

The pulsed plasma discharge is of high intensity but of low average power. During each 'on' period an intense radio frequency grade causes substantially complete dissolution of the gas constituting the plasma. The active species thus produced during the pulse then react in the subsequent 'off' period.

We have now found that a further significant improvement in the pulsed plasma process may be obtained by confining the plasma discharge to the immediate vicinity of the substrate.

According to one aspect of the invention there is provided a method of surface treatment of a substrate body by exposing the body surface to a pulsed radio frequency plasma discharge, the plasma being substantially completely dissociated during each said pulse, characterised in that for the treatment of a laminar substrate body the plasma discharge is confined to a region adjacent the body surface by means of a reactor vessel having an internal rectangular cross section corresponding to the configuration of the substrate body, or by means of an insert within the reactor vessel having said internal rectangular cross section and surrounding said laminar substrate body.

According to another aspect of the invention there is provided a reactor vessel for surface treatment with a pulsed radio-frequency plasma of a laminar substrate body disposed in said reactor vessel, characterised in that the reactor vessel has an internal surface with a substantially rectangular cross section corresponding to the configuration of the substrate body whereby, in use, the plasma is confined adjacent the body surface.

As the active species in the plasma are prevented from escaping from the region adjacent the substrate surface a high conversion efficiency is obtained.

It will be appreciated that because of both the discontinuous nature of the discharge and the high energy density conditions present during each radio frequency pulse, conventional low power continuous plasma techniques cannot be employed to provide maximum coupling efficiency to the discharge.

An embodiment of the invention will now be described with reference to the accompanying drawings in which:

Fig. 1 is a schematic diagram of a pulsed plasma processing apparatus;

Fig. 2 is a part sectional view of a reactor vessel for use in the apparatus of Fig. 1;

Fig. 3 is a cross-sectional view of an alternative reactor vessel, and

Fig. 4 shows a modified cross-section of the vessel of Fig. 2 or Fig. 3.

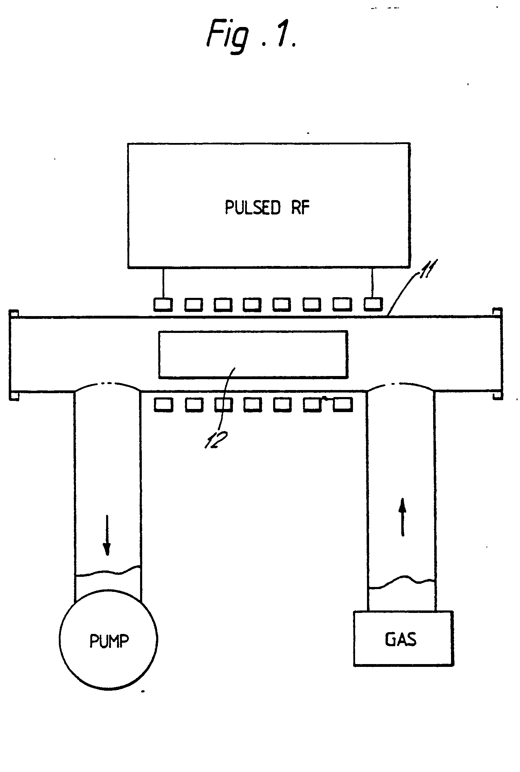

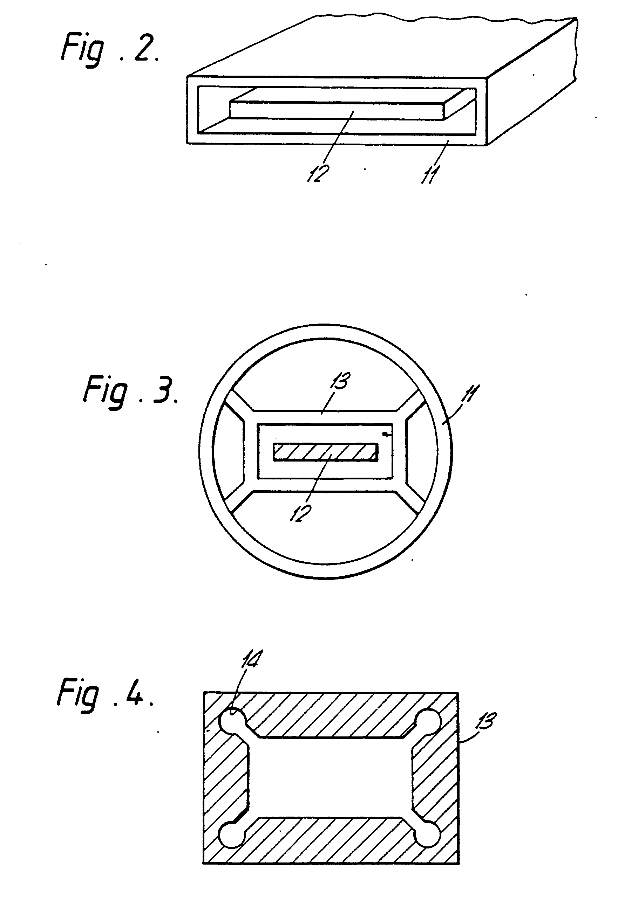

Referring to Fig. 1, the plasma reactor vessel comprises a tubular body 11 having a cross-sectioned configuration corresponding to the shape of a substrate body 12 to be processed. Where the body 12 is laminar, e.g. a printed circuit board, the reactor vessel 11 is rectangular in cross-section as is shown in Fig. 2. Alternatively the plasma may be restricted to a region adjacent the substrate by shaped insert 13 (Fig. 3) placed in the vessel 11 and surrounding the body 12. A low pressure gas from which the plasma is to be formed is pumped through the vessel 11. Typically the plasma is maintained at a pressure of $1.33 \times 10^{-1}$ to $1.33 \times 10^2$ newtons m$^{-2}$ (1 to 1000 mtorr).

Advantageously the space between the insert 13 and the vessel 11 is sealed and pumped separately to a pressure high enough, typically $1.33 \times 10^4$ to $2.66 \times 10^4$ newtons m$^{-2}$ (100 to 200 torr), to inhibit plasma formation. The same effect may be achieved by filling this space with a fibrous material, e.g. glass wool.

To affect surface treatment, e.g. etching or deposition, of the substrate body 12 pulsed radio frequency power is applied to the reactor vessel 11 via a work coil surrounding the vessel and coupled to a generator (not shown). The power output of the generator is not critical but must be sufficient to provide the desired surface processing effect, i.e. sufficient to provide substantially complete dissolution of the plasma. We have found that pulse powers of 200 w/cm$^2$ to 250 w/cm$^2$ of the treated surface are adequate for this purpose. We have also found that the etching or deposition rate may be improved by the provision of longitudinal grooves 14 (Fig. 4) in the wall of the vessel 11 or the insert 13. When an electrically conductive material is being deposited the provision of longitudinal grooves in the insert 13 or the vessel 11 inhibits the formation of a continuous conductor loop which would provide a 'shorted turn' inhibiting coupling of radio frequency power to the plasma. For this purpose the grooves should have a small opening and a relatively large internal surface area.

Advantageously the generator pulse rate is matched to the gas exchange rate within the reactor vessel, i.e. the pulse rate is matched to the pumping speed such that one pulse is applied for each replenishment of gas in the vessel 11. Such a technique is described in our co-pending application No. 8505319 (R. A. H. Heinecke et al 38-6-1X). In some applications local intensification of the plasma may be provided by an applied magnetic field.

We have found that for optimum efficiency of the process the pulsed plasma should be confined to a region within 15 to 25 mm from the substrate surface. If, for example, the substrate is a circuit board 1 to 4 mm in thickness then the smaller dimension of the rectangular cross-section of the vessel 11 should be 31 to 44 mm.

For example, we have coated silicon wafer substrates with silicon nitride, silicon oxide and silicon using both confined and unconfined plasmas. Films of silicon nitride (from silane and nitrogen), silicon oxide (from silane and carbon dioxide) and silicon (from silane) have been deposited on 4 inch silicon wafers. Examination of interference fringes using light of a wavelength of 500 nanometres (5000 Å) has shown that, for plasma confinement to the range specified above, a uniformity of 250 nanometres (2500 Å) over the wafer surface of the above surface films is achieved for coating thicknesses in the range 0.3 to 5 microns. Outside this confinement region surface variations greater than 250 nanometres (2,500 Å) were observed. Deposition was performed at pressures in the range $1.33 \times 10^{-1}$ to $1.33 \times 10^{2}$ newtons $m^{-2}$ (1 to 1000 mtorr) and a greater pulse power density of 220 watt/cm$^2$ of the wafer surface.

## Claims

1. A method of surface treatment of a substrate body by exposing the body surface to a pulsed radio frequency plasma discharge, the plasma being substantially completely dissociated during each said pulse, characterised in that for the treatment of a laminar substrate body the plasma discharge is confined to a region adjacent the body surface by means of a reactor vessel having an internal rectangular cross section corresponding to the configuration of the substrate body, or by means of an insert within the reactor vessel having said internal rectangular cross section and surrounding said laminar substrate body.

2. A method as claimed in claim 1, characterised in that the plasma discharge is confined to a region extending 15 to 25 mm from the body surface.

3. A method as claimed in claim 1 or 2, characterised in that the plasma discharge is further confined by an applied magnetic field.

4. A method as claimed in any one of claims 1 to 3, characterised in that the plasma discharge is maintained at a pressure of $1.33 \times 10^{-1}$ to $1.33 \times 10^{2}$ newtons $m^2$ (1 to 1000 mtorr).

5. A method as claimed in any one of claims 1 to 4, characterised in that the plasma discharge is subjected to a peak power of 200 to 250 watts/cm$^2$ of the substrate surface area.

6. A reactor vessel for surface treatment with a pulsed radio-frequency plasma of a laminar substrate body disposed in said reactor vessel, characterised in that the reactor vessel has an internal surface with a substantially rectangular cross-section corresponding to the configuration of the substrate body whereby, in use, the plasma is confined adjacent the body surface.

7. A reactor vessel as claimed in claim 6 characterised in that, in use, the plasma is confined to a region within 15 to 25 mm of the body surface.

8. A reactor vessel as claimed in claim 6 or 7, characterised in that said internal surface is provided on a demountable insert.

9. A reactor vessel as claimed in claim 6, 7 or 8, characterised in that said internal surface has one or more longitudinal grooves so shaped as to inhibit plasma deposition of material therein.

10. A reactor vessel as claimed in claim 6, 7, 8 or 9, characterised in that for a 1 to 4 mm thick substrate body the smaller dimension of the rectangular cross-section is 31 to 44 mm.

## Patentansprüche

1. Verfahren zur Oberflächenbehandlung eines Substratkörpers durch Beaufschlagen der Körperoberfläche mit einer Impuls-Hochfrequenz- Plasmaentladung, wobei das Plasma während jedes Impulses im wesentlichen vollständig dissoziiert wird, dadurch gekennzeichnet, daß für die Behandlung eines flächenförmigen Substratkörpers die Plasmaentladung auf einen Bereich benachbart zur Substratkörperoberfläche mit Hilfe eines Reaktorgefäßes mit einem rechtwinkeligen Innenquerschnitt, der der Form des Substratkörpers entspricht, oder mit Hilfe eines Einsatzes in dem Reaktorgefäß beschränkt wird, der den rechtwinkeligen Innenquerschnitt aufweist und den flächenförmigen Substratkörper umgibt.

2. Verfahren nach Anspruch 1, dadurch gekennzeichnet, daß die Plasmaentladung auf einen Bereich beschränkt ist, der sich 15 bis 25 mm von der Substratkörperoberfläche erstreckt.

3. Verfahren nach Anspruch 1 oder 2, dadurch gekennzeichnet, daß die Plasmaentladung weiter durch ein angelegtes Magnetfeld beschränkt ist.

4. Verfahren nach einem der Ansprüche 1 bis 3, dadurch gekennzeichnet, daß die Plasmaentladung bei einem Druck von $1,33 \times 10^{-1}$ bis $1,33 \times 10^{2}$ Newton $m^2$ (1 bis 1000 mtorr) aufrechterhalten wird.

5. Verfahren nach einem der Ansprüche 1 bis 4, dadurch gekennzeichnet, daß die Plasmaentladung einer Spitzenleistung von 200 bis 500 Watt/cm² des Substratoberflächenbereiches ausgesetzt wird.

6. Reaktorgefäß für die Oberflächenbehandlung eines in dem Reaktorgefäß angeordneten flächenförmigen Substratkörpers mit einem Impuls-Hochfrequenz-Plasma, dadurch gekennzeichnet, daß das Reaktorgefäß eine Innenoberfläche mit einem im wesentlichen rechtwinkeligen Querschnitt aufweist, der der Form des Substratkörpers entspricht, so daß im Gebrauch das Plasma auf einen Bereich benachbart zur Substratkörperoberfläche beschränkt ist.

7. Reaktorgefäß nach Anspruch 6, dadurch gekennzeichnet, daß im Gebrauch das Plasma auf einen Bereich innerhalb von 15 bis 25 mm der Körperoberfläche beschränkt ist.

8. Reaktorgefäß nach Anspruch 6 oder 7, dadurch gekennzeichnet daß die Innenoberfläche auf einem demontierbaren Einsatz vorgesehen ist.

9. Reaktorgefäß nach Anspruch 6, 7 oder 8, dadurch gekennzeichnet, daß die Innenoberfläche eine oder mehrere längsverlaufende Nuten aufweist, die so geformt sind, daß sie die Plasma-Materialabscheidung in diesen hemmen.

10. Reaktorgefäß nach Anspruch 6, 7, 8 oder 9, dadurch gekennzeichnet, daß für einen 1 bis 4 mm dicken Substratkörper die kleinere Abmessung des rechtwinkeligen Querschnittes 31 bis 44 mm beträgt.

**Revendications**

1. Procédé de traitement de la surface d'un corps constituant un substrat, par exposition de la surface du corps à une décharge pulsée de plasma à radiofréquences, le plasma étant quasi-totalement dissocié pendant ladite impulsion, procédé caractérisé en ce que, pour le traitement d'un corps de substrat laminaire, la décharge de plasma est confinée à une région voisine de la surface du corps, à l'aide d'un récipient de réacteur ayant une section transversale rectangulaire intérieure correspondant à la configuration du corps formant substrat, ou à l'aide d'une pièce insérée au sein du récipient de réacteur, cette pièce ayant ladite section transversale rectangulaire interne et entourant ledit corps de substrat laminaire.

2. Procédé tel que revendiqué à la revendication 1, caractérisé en ce que la décharge de plasma est confinée à une région s'étendant sur 15 à 25 mm à partir de la surface du corps.

3. Procédé tel que revendiqué à la revendication 1 ou 2, caractérisé en ce que la décharge de plasma est encore plus confinée grâce à un champ magnétique appliqué.

4. Procédé tel que revendiqué dans l'une quelconque des revendications 1 à 3, caractérisé en ce que la décharge de plasma est maintenue à une pression de $1{,}33 \times 10^{-1}$ à $1{,}33 \times 10^{2}$ Nm$^{-2}$ (1 à 1000 mtorrs).

5. Procédé tel que revendiqué dans l'une quelconque des revendications 1 à 4, caractérisé en ce que la décharge de plasma est soumise à une énergie de pic de 200 à 250 W/cm² de l'aire de surface du substrat.

6. Récipient de réacteur pour traiter en surface, à l'aide d'un plasma pulsé à radiofréquences un corps formant un substrat laminaire disposé dans ledit récipient de réacteur, caractérisé en ce que le récipient de réacteur possède une surface intérieure ayant une section transversale sensiblement rectangulaire correspondant à la configuration du corps formant substrat, de sorte que, en service, le plasma est confiné au voisinage de la surface du corps.

7. Récipient de réacteur tel que revendiqué à la revendication 6, caractérisé en ce que, en service, le plasma est confiné à une région se situant entre 15 et 25 mm de la surface du corps.

8. Récipient de réacteur tel que revendiqué à la revendication 6 ou 7, caractérisé en ce que ladite surface interne est munie d'une pièce insérée démontable.

9. Récipient de réacteur tel que revendiqué à la revendication 6, 7 ou 8, caractérisé en ce que ladite surface interne comporte une ou plusieurs rainures longitudinales configurées de manière à y inhiber un dépôt de matière par le plasma.

10. Récipient de réacteur tel que revendiqué à la revendication 6, 7, 8 ou 9, caractérisé en ce que, pour un corps formant substrat de 1 à 4 mm d'épaisseur, la plus petite dimension de la section transversale rectangulaire est de 31 à 44 mm.

# Fig .1.

PULSED RF

11

12

PUMP

GAS

Fig . 2.

Fig . 3.

Fig . 4.